# EUROPEAN PATENT APPLICATION

(11) **EP 4 657 190 A1**
(43) Date of publication of application: **03.12.2025**
(21) Application number: 24756580.7
(22) Date of filing: 23.01.2024
(51) Int. Cl.: G05B 19/418, B23K 1/008, H05K 13/00

(54) **CONTROL DEVICE, CONTROL METHOD, AND PROGRAM**

(30) Priority: 17.02.2023 JP 2023023658
(71) Applicant: OMRON Corporation, Kyoto 600-8530 (JP)
(72) Inventor: TAKAICHI, Ryuichiro, Kyoto-shi, Kyoto 600-8530 (JP); NAKATANI, Yuya, Kyoto-shi, Kyoto 600-8530 (JP)
(74) Representative: Isarpatent
(86) International application number: PCT/JP2024/001774
(87) International publication number: WO 2024/171729

(57) **Abstract**

A control device for at least one production facility having a first mode of maintaining a first state in which an interior of a hollow part of the production facility is heated and gas in the interior of the hollow part is emitted out of a manufacturing chamber and a second mode of maintaining a second state in which energy consumption is lower than in the first state, includes an instruction unit that issues an instruction for increasing an amount of air supply into the manufacturing chamber to an air conditioning control unit that controls an air conditioning facility that maintains a positive pressure in the inside of the manufacturing chamber in which the production facility is arranged before the production facility transitions from the second state to the first state.

## Description

### TECHNICAL FIELD

The present invention relates to a control device, a control method, and a program.

### BACKGROUND OF INVENTION

Energy saving technologies in production facilities such as factories have attracted attention in response to environmental problems and demand for cost reduction. For example, even when a production facility is in an operating state, production is not always performed, and there is a time period during which operators are absent due to a break or a shift change, or a time period during which production apparatuses are idling due to a set-up change or the like. Although a production facility is stopped by switching the production facility from an operation mode to a stop mode, it is impossible to completely stop the production facility during operation of the production line because a considerable time is required to start up the production facility. Various studies have been made on reduction of energy consumption, and among them, various technologies have been proposed for reduction of energy consumption in the industrial field (for example, refer to Patent Documents 1 and 2). Patent Documents 1 and 2 describe that energy-saving control is performed in which apparatuses are held standby in a state of low energy consumption (referred to as a standby mode, an energy-saving mode, or the like) during idling (during non-production), and the apparatuses are switched to an operation mode in accordance with the resumption of production to quickly transition to a state in which production is possible.

### CITATION LIST

### PATENT DOCUMENTS

Patent Document 1: Japanese Unexamined Patent Application Publication No. 2013-098417
Patent Document 2: Japanese Unexamined Patent Application Publication No. 2014-186656

### SUMMARY

### TECHNICAL PROBLEM

In order to maintain the quality of products, a manufacturing chamber (production room) in the factory needs to be kept in a positive pressure state. Since the known positive pressure control system is follow-up control, when the production facility is switched from the standby mode or the stop mode to the operation mode, the total exhaust from the manufacturing chamber increases due to an increase in the exhaust from the production facility, and the positive pressure state in the manufacturing chamber is not maintained, which may cause defects in products.

The present invention has been made in view of the above circumstances, and an object of the present invention is to provide a technique capable of maintaining a positive pressure state in a manufacturing chamber.

### SOLUTION TO PROBLEM

A control device according to one aspect of the present invention is a control device for at least one production facility having a first mode of maintaining a first state in which an interior of a hollow part of the production facility is heated and gas in the interior of the hollow part is emitted out of a manufacturing chamber and a second mode of maintaining a second state in which energy consumption is lower than in the first state, the control device including an instruction unit that issues an instruction for increasing an amount of air supply into the manufacturing chamber to an air conditioning control unit that controls an air conditioning facility that maintains a positive pressure in the manufacturing chamber in which the production facility is arranged before the production facility transitions from the second state to the first state.

According to this configuration, when an operator is absent due to a break, a shift change, or the like, or when the production is temporarily stopped due to a set-up change or the like, switching the production facility to the second mode makes it possible to suppress wasteful energy consumption. The switching to the second mode may be manually instructed by the operator or may be automatically performed. The "energy" here may include not only energy directly supplied to the production facility (electric power, heat, force, or the like) but also energy indirectly required to operate the production facility, for example, energy required to manufacture, transport, store, and supply substances (atmospheric gas, cooling liquid, cleaning liquid, catalyst, or the like) used in the production facility.

The air conditioning facility maintains the interior of the manufacturing chamber at a positive pressure by controlling the amount of air supplied into the manufacturing chamber and the amount of air supply (the amount of air exhausted) from the manufacturing chamber. When the production facility switches from the second mode to the first mode, the gas in the interior of the hollow part of the production facility is emitted out of the manufacturing chamber. Therefore, the amount of air supply from the manufacturing chamber increases in the case where the production facility is in the first mode, as compared with the case where the production facility is in the second mode. Before the production facility switches from the second mode to the first mode, that is, before the production facility transitions from the second state to the first state, an instruction for increasing the amount of air supply into the manufacturing chamber is issued to an air conditioning control unit that controls the air conditioning facility. Accordingly, since the amount of air supplied into the manufacturing chamber increases before the production facility transitions from the second state to the first state, the interior of the manufacturing chamber can be maintained at a positive pressure even when the amount of air supply from the manufacturing chamber increases due to the transition of the production facility from the second state to the first state.

The instruction for increasing the amount of air supply into the manufacturing chamber may include an instruction related to a timing of increasing the amount of air supply into the manufacturing chamber, an increase rate, and an increase holding time. The air conditioning control unit determines an increase amount of air supply into the manufacturing chamber, based on the increase rate of the amount of air supply into the manufacturing chamber. If the current time reaches the timing of increasing (increase start time) of amount of air supply into the manufacturing chamber, the air conditioning control unit controls the air conditioning facility, and the air conditioning facility increases the amount of air supply into the manufacturing chamber. The air conditioning control unit controls the air conditioning facility so as to maintain the state in which the amount of air supply into the manufacturing chamber is increased until after lapse of the increase holding time of the amount of air supply into the manufacturing chamber.

The control device may further include a storage unit that stores a set value of a transition time period expected to be required for the production facility to enter a production start enabled state from the second state, and the instruction unit may determine a switching time at which switching from the second mode to the first mode is performed, based on a time at which the production facility enters the production start enabled state and the set value of the transition time period stored in the storage unit, and determine the timing of increasing the amount of air supply into the manufacturing chamber, based on the switching time.

The control device according to one aspect of the present invention may include a measurement unit that measures a second transition time period actually required until the production facility enters the production start enabled state after switching from the second mode to the first mode one or more times, and an update unit that updates the set value of the transition time period stored in the storage unit based on a measurement value of the second transition time period measured one or more times by the measurement unit.

The storage unit may store operation parameters related to an operation of the production facility and the set value of the transition time period for each of the operation parameters in association with each other, the measurement unit may measure the second transition time period for each of the operation parameters one or more times, and the update unit may update the set value of the transition time period for each of the operation parameters stored in the storage unit, based on the measurement value of the second transition time period for each of the operation parameters measured by the measurement unit one or more times. The operation parameters may include at least one of a type of a product produced by the production facility, worker information of a worker who is engaged in the production facility in the first mode, facility information of the production facility, external environment information of surroundings of the production facility, a type of a material of the product, and a type of a method used in the production facility.

The production facility may be a reflow furnace that heats solder paste on a substrate, the first mode may be an operation mode in which power is supplied to a heater in the reflow furnace to heat an inside of the reflow furnace and power is supplied to a fan in the reflow furnace to emit gas in the reflow furnace out of the manufacturing chamber, and the second mode may be a standby mode of being on standby in the second state while supply of power to the heater is stopped or an amount of power supply to the heater is reduced, and the supply of power to the fan is stopped or the amount of driving of the fan is reduced. The production facility may be a reflow furnace that heats solder paste on a substrate, the first mode may be an operation mode in which power is supplied to a heater in the reflow furnace to heat an inside of the reflow furnace and power is supplied to a fan in the reflow furnace to emit gas in the reflow furnace out of the manufacturing chamber, and the second mode may be a stop mode in which the supply of power to the heater and the fan is stopped to stop operation.

The production facility may have a duct for emitting the gas out of the manufacturing chamber, and include a duct control unit that controls an opening degree of the duct based on a differential pressure between a pressure in the manufacturing chamber and a pressure in the duct.

A control method according to one aspect of the present invention is a control method for at least one production facility having a first mode of maintaining a first state in which an interior of a hollow part of the production facility is heated and gas in the interior of the hollow part is emitted out of a manufacturing chamber and a second mode of maintaining a second state in which energy consumption is lower than in the first state, wherein the control method includes issuing an instruction for increasing an amount of air supply into the manufacturing chamber to an air conditioning facility that maintains a positive pressure in the manufacturing chamber in which the production facility is arranged before the production facility transitions from the second state to the first state.

A program according to one aspect of the present invention is a program for causing a control device of at least one production facility having a first mode of maintaining a first state in which an interior of a hollow part of the production facility is heated and gas in the interior of the hollow part is emitted out of a manufacturing chamber and a second mode of maintaining a second state in which energy consumption is lower than in the first state, to execute issuing an instruction for increasing an amount of air supply into the manufacturing chamber to an air conditioning facility that maintains a positive pressure in the manufacturing chamber in which the production facility is arranged before the production facility transitions from the second state to the first state.

### ADVANTAGEOUS EFFECTS OF INVENTION

According to the present invention, it is possible to maintain a positive pressure state in a manufacturing chamber.

### BRIEF DESCRIPTION OF THE DRAWINGS

[FIG. 1] FIG. 1 is a diagram illustrating an overall configuration of a system to which the present invention is applied.
[FIG. 2] FIG. 2 is a diagram illustrating a configuration of a reflow furnace.
[FIG. 3] FIG. 3 is a diagram illustrating an example of a configuration of a control device.
[FIG. 4] FIG. 4 is a diagram illustrating an example of a flow executed at the time of switching the reflow furnace to an energy-saving mode.
[FIG. 5] FIG. 5 is a diagram illustrating an example of an operation panel of an IPC.
[FIG. 6] FIG. 6 is a diagram illustrating an example of the operation panel of the IPC.
[FIG. 7] FIG. 7 is an explanatory diagram of an energy-saving mode time and a start-up time.
[FIG. 8] FIG. 8 is a diagram illustrating a transition time prediction model.
[FIG. 9] FIG. 9 is a diagram illustrating an example of a flow of calculation processing of transition time.
[FIG. 10] FIG. 10 is a diagram illustrating an example of the operation panel of the IPC.
[FIG. 11] FIG. 11 is a diagram illustrating an example of a flow of displaying a differential pressure on a display device of the IPC.
[FIG. 12] FIG. 12 is a diagram illustrating a display example of a target value of a differential pressure, raw data, and moving variance.
[FIG. 13] FIG. 13 is a diagram illustrating an example of a flow of damper control.
[FIG. 14] FIG. 14 is an explanatory diagram of a determination process of a duct opening degree and a control process of the duct opening degree.
[FIG. 15] FIG. 15 is a diagram illustrating an example of an instruction flow from the IPC to the instrumentation control device.
[FIG. 16] FIG. 16 is a diagram illustrating an example of a control flow in a case where an abnormality occurs in a standby mode or a stop mode.
[FIG. 17] FIG. 17 is a block diagram illustrating a functional configuration of the IPC.

### DESCRIPTION OF EMBODIMENTS

Hereinafter, application examples and embodiments will be described with reference to the drawings. The application examples and embodiments described below are aspects of the present application, and do not limit the scope of rights of the present application.

### <Application Example>

An application example of the present invention will be described. The present invention relates to a control device that performs energy-saving control of a production facility, and a control method thereof. The control device may be a unit separate from or external to the production facility, or may be a unit integrated with or built in the production facility. The control device can be applied to any type of production facility as long as the production facility has a plurality of modes. The production facility is a facility related to the production of products and refers to a facility having a hollow part. The production facility typically corresponds to a manufacturing apparatus or a processing apparatus, but the production facility also corresponds to a facility indirectly contributing to production, for example, a transportation apparatus, a storage facility, a clean room, an air conditioner, a lighting device, and the like. In the following embodiment, control of a reflow furnace for heating a solder paste on a substrate is taken as a preferred application example of the present invention.

### [Outline of System]

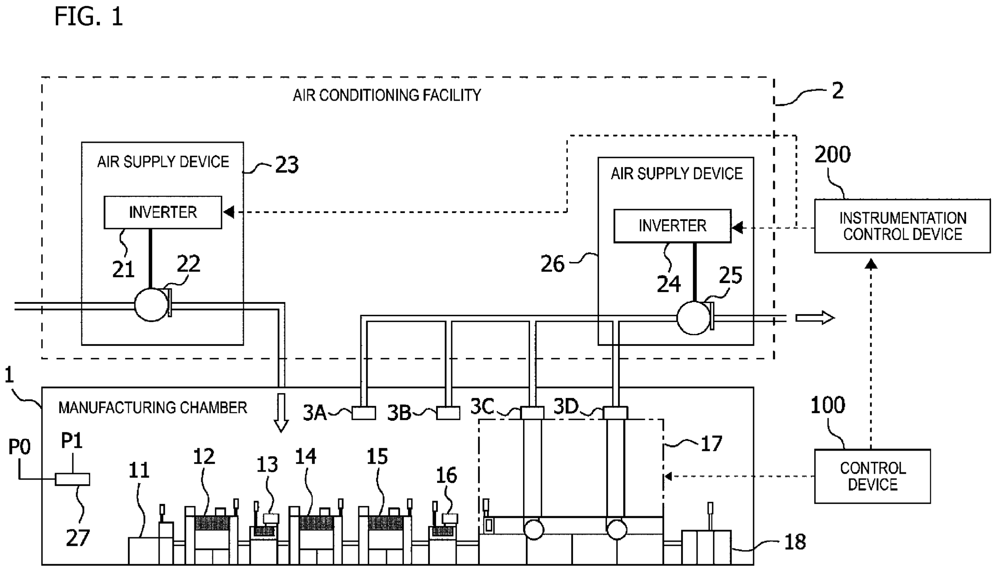

FIG. 1 is a diagram illustrating an overall configuration of a system to which the present invention is applied. A schematic configuration of the system will be described with reference to FIG. 1. In the system of FIG. 1, cooperative control of factory automation (FA) and building automation (BA) is performed, for example. The system of FIG. 1 includes a control device 100 that controls a production facility arranged in a manufacturing chamber (production room) 1, and an instrumentation control device 200 that controls an air conditioning facility 2. The control device (control system) 100 may be formed of an industrial personal computer (IPC), a programmable logic controller (PLC), a reflow furnace PLC, and the like.

The air conditioning facility 2 includes an air supply device 23 provided with an inverter 21 and an air supply fan 22, and an air supply device 26 provided with an inverter 24 and an air supply fan 25. The air conditioning facility 2 maintains the inside of the manufacturing chamber 1 at a positive pressure by controlling the amount of air supply into the manufacturing chamber 1 and the amount of air supply (the amount of air exhausted) from the inside of the manufacturing chamber 1. For example, the air conditioning facility 2 controls the amount of air supply into the manufacturing chamber 1 and the amount of air supply from the inside of the manufacturing chamber 1 such that a pressure P1 inside the manufacturing chamber 1 measured by a differential pressure sensor 27 is higher than a pressure P0 outside of the manufacturing chamber 1 measured by the differential pressure sensor 27. The inverter 21 controls the air supply fan 22 based on an instruction from the instrumentation control device 200, thereby adjusting the amount of air supply into the manufacturing chamber 1. The inverter 24 controls the air supply fan 25 based on an instruction from the instrumentation control device 200, thereby adjusting the amount of air supply from the inside of the manufacturing chamber 1. The air in the manufacturing chamber 1 is emitted out of the manufacturing chamber 1 through air supply ports 3A and 3B provided in the manufacturing chamber. The instrumentation control device 200 is an example of an air conditioning control unit that controls the air conditioning facility 2.

The production facility arranged in the manufacturing chamber 1 includes a loader 11, a solder printer 12, an inspection device 13, a high-speed mounter 14, a high-precision mounter 15, an inspection device 16, a reflow furnace 17, and an unloader 18. The numbers of the loader 11, the solder printer 12, the inspection device 13, the high-speed mounter 14, the high-precision mounter 15, the inspection device 16, the reflow furnace 17, and the unloader 18 may each be one or more. In the manufacturing chamber 1, a printed board to be processed is fed to the loader 11, the solder printer 12, the inspection device 13, the high-speed mounter 14, the high-precision mounter 15, the inspection device 16, the reflow furnace 17, and the unloader 18 in this order.

Solder paste is printed on the printed board fed from the loader 11 by the solder printer 12. After the quality of the printing is inspected by the inspection device 13, electronic components are mounted on the printed board by the high-speed mounter 14 and the high-precision mounter 15. After the quality of the mounting is inspected by the inspection device 16, the printed board on which the electronic components are mounted is put into the reflow furnace 17. In the present specification, a printed board on which electronic components are mounted is referred to as "workpiece". After the solder paste is melted in the reflow furnace 17 to fix the electronic components, the workpiece is fed to various processes via the unloader 18.

The loader 11, the solder printer 12, the inspection device 13, the high-speed mounter 14, the high-precision mounter 15, the inspection device 16, the reflow furnace 17, and the unloader 18 include emergency lamps, and the operations of the emergency lamps are controlled by their respective control devices. In the event of an emergency, each control device turns on the corresponding emergency lamp.

### (Reflow Furnace)

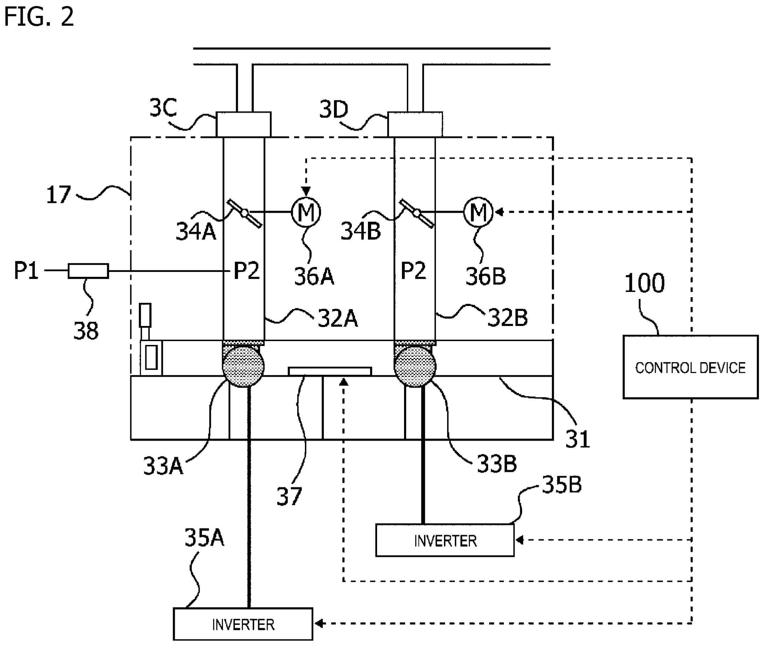

A configuration of the reflow furnace 17 will be described in detail with reference to FIG. 2. FIG. 2 is a diagram illustrating a configuration of the reflow furnace 17. The reflow furnace 17 is provided with a hollow inert atmosphere chamber 31. The inert atmosphere chamber 31 is provided with ducts 32A and 32B. The duct 32A is provided with a fan 33A and an opening/closing plate 34A, and the duct 32B is provided with a fan 33B and an opening/closing plate 34B. Based on an instruction from the control device 100, an inverter 35A controls the fan 33A, and an inverter 35B controls the fan 33B, so that the air flows in the ducts 32A and 32B. The gas in an interior of the hollow part of the reflow furnace 17 is emitted out of the manufacturing chamber 1 through the ducts 32A, 32B, and air supply ports 3C, 3D provided in the manufacturing chamber 1.

The opening/closing plates 34A and 34B are provided to adjust the degree of air flow in the ducts 32A and 32B, respectively. The degrees of opening/closing of air passages in the ducts 32A and 32B by the opening/closing plates 34A and 34B are controlled by damper motors 36A and 36B, respectively. Hereinafter, the degree of opening/closing of the air passage in the duct 32A will be referred to as the opening degree of the duct 32A, and the degree of opening/closing of the air passage in the duct 32B will be referred to as the opening degree of the duct 32B. The control device 100 controls the driving of the damper motors 36A and 36B.

The inert atmosphere chamber 31 is provided with a heater 37 which is a heating device for heating the inside of the inert atmosphere chamber 31. The control device 100 controls the heating operation of the heater 37 in the reflow furnace 17. The duct 32A is provided with a differential pressure sensor 38. The differential pressure sensor 38 measures the pressure P1 in the manufacturing chamber 1 and a pressure P2 in the duct 32A. The differential pressure sensor 38 may be provided on the duct 32B, and in this case, the differential pressure sensor 38 measures the pressure P1 in the manufacturing chamber 1 and the pressure P2 in the duct 32B.

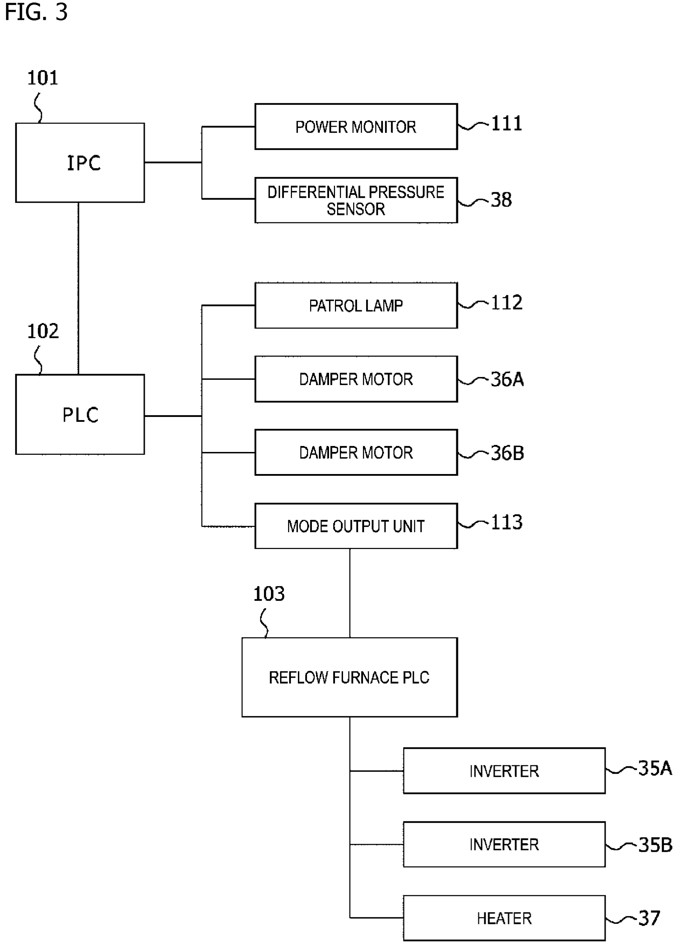

FIG. 3 is a diagram illustrating an example of a configuration of the control device 100. In the example illustrated in FIG. 3, the control device 100 includes an IPC 101, a PLC 102, and a reflow furnace PLC 103. A power monitor 111 detects the power consumption of the production facility arranged in the manufacturing chamber 1, and sends the detected power consumption amount to the IPC 101. The differential pressure sensor 38 measures the differential pressure between the pressure P1 in the manufacturing chamber 1 and the pressure P2 in the duct 32A, and sends the measurement value (differential pressure data) to the IPC 101. The differential pressure sensor 38 may measure the differential pressure between the pressure P1 in the manufacturing chamber 1 and the pressure P2 in the duct 32B, and send the measurement value (differential pressure data) to the IPC 101. A patrol lamp 112 performs display according to the state of the reflow furnace 17 based on the instruction from the PLC 102. The patrol lamp 112 outputs the display in a combination of a lighting color of a light, a blinking (lighting) pattern, and the like. The PLC 102 issues a command to the damper motors 36A and 36B to control the degrees of opening/closing of the opening/closing plates 34A and 34B. A mode output unit 113 transmits a signal related to mode switching performed by the PLC 102 to the reflow furnace PLC 103. The reflow furnace PLC 103 controls the inverters 35A, 35B and the heater 37.

The IPC 101, the PLC 102, and the reflow furnace PLC 103 include an arithmetic device such as a central processing unit (CPU), a storage device for storing various types of data such as programs, and a communication interface used for communication. The storage device is a memory (volatile storage device) such as a dynamic random access memory (DRAM) or a static random access memory (SRAM), or a storage (non-volatile storage device) such as a hard disk drive (HDD) or a solid state drive (SSD), for example. The communication interface is implemented by a communication device such as a network card. The arithmetic devices of the IPC 101, the PLC 102, and the reflow furnace PLC 103 execute programs stored in the storage device, for example, to realize various operations. The memories of the IPC 101, the PLC 102, and the reflow furnace PLC 103 may be implemented by removable storage media. The hardware configuration of the instrumentation control device 200 is the same as the hardware configuration of the IPC 101, the PLC 102, and the reflow furnace PLC 103.

### (Energy Saving Control of Reflow Furnace)

During the operation of the board production line, it is necessary to maintain the reflow furnace 17 in a state where the production (heat treatment) of the workpiece can be performed with stable quality, in principle. To this end, it is necessary to maintain the reflow furnace 17 in a state in which the interior of the hollow part of the reflow furnace 17 is heated and the gas in the hollow part of the reflow furnace 17 is emitted out of the manufacturing chamber 1 (referred to as a "first state"). The workpiece to be processed is not always put into the reflow furnace 17. The putting of the workpiece into the reflow furnace 17 may be temporarily stopped during a time when no worker is present due to a break or a shift change, during a time of a set-up change, or at the occurrence of an abnormality, for example. Therefore, the reflow furnace 17 of the present embodiment has a first mode (referred to as an "operation mode") in which the interior of the hollow part of the reflow furnace is heated and the gas in the hollow part of the reflow furnace 17 is emitted out of the manufacturing chamber 1, and a second mode in which the reflow furnace is maintained in a state in which the energy consumption is lower than that in the first state (referred to as a "second state"). The second mode is a standby mode in which the operation is on standby in the second state or a stop mode in which the operation is stopped. The energy consumption during non-production is suppressed by switching the operation mode of the reflow furnace 17 from the operation mode to the standby mode as necessary. In the standby mode, for example, the energy consumption is suppressed by stopping the driving of the fans 33A and 33B, reducing the amounts of driving of the fans 33A and 33B, stopping the supply of power to the heater 37, reducing the amount of supply of power to the heater 37, or the like. The amounts of driving of the fans 33A and 33B may be reduced by decreasing the rotation speeds of the fans 33A and 33B. The amounts of driving of the fans 33A and 33B may be reduced by switching the fans 33A and 33B from continuous driving to intermittent driving. In the standby mode, the reflow furnace 17 has a role of maintaining the thermal energy accumulated in the operation mode. In the standby mode, maintaining the thermal energy brings the temperature start time at restart of the reflow furnace 17 close to the target value, which produces an effect of suppressing the consumption of energy required for starting the reflow furnace 17. In order to maintain the atmosphere in the reflow furnace 17, (1) the supply of compressed air to the reflow furnace 17 may be stopped (the main valve of the supply air is closed), (2) the emission of the air from the reflow furnace 17 may be reduced, or the like. Switching the operation mode of the reflow furnace 17 from the operation mode to the standby mode will also be referred to as "switching the reflow furnace 17 to the energy-saving mode".

The operation of the reflow furnace 17 is stopped in the case of halting the board production line or performing maintenance of the reflow furnace 17. The energy consumption during non-production is suppressed by switching the operation mode of the reflow furnace 17 from the operation mode to the stop mode as necessary. For example, when the supply of power to the heater 37 is stopped in a state where the fans 33A and 33B are being driven, the heating in the reflow furnace 17 is stopped, but the exhaust from the reflow furnace 17 continues, so that the temperature in the reflow furnace 17 may rapidly decrease. In this case, even if the heating in the reflow furnace 17 is started at a relatively early stage after the operation of the reflow furnace 17 is stopped, the time required for the temperature inside the reflow furnace 17 to reach the target temperature will become long with large heat loss. In the present embodiment, in the stop mode of the reflow furnace 17, the driving of the fans 33A and 33B is stopped and the supply of power to the heater 37 is stopped, so that the temperature in the reflow furnace 17 is gradually decreased. Accordingly, in the case of switching the operation mode of the reflow furnace 17 from the stop mode to the operation mode, it is possible to shorten the time required for the temperature in the reflow furnace 17 to reach the target temperature, and suppress energy consumption.

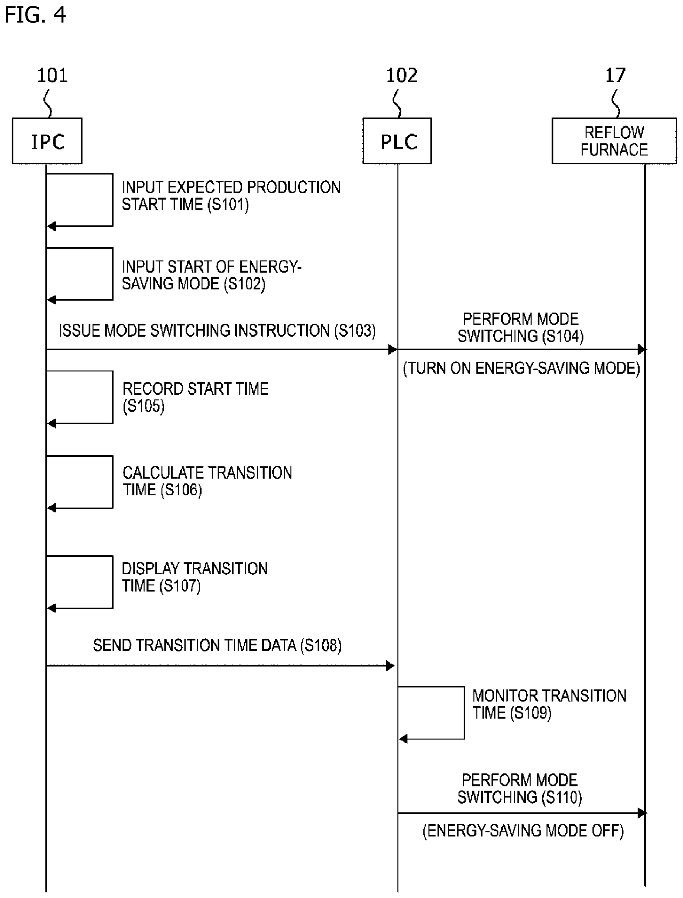

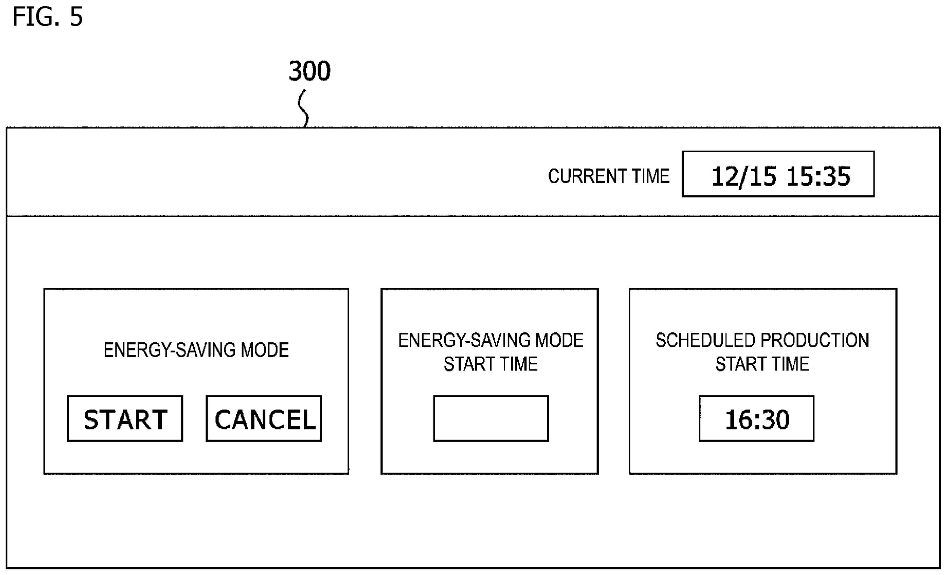

Next, a flow of processing by the present system will be described with reference to FIGS. 4 to 10. FIG. 4 is a diagram illustrating an example of a flow of processing executed at the time of switching the reflow furnace 17 to the energy-saving mode. A process of switching the reflow furnace 17 to the energy-saving mode will be described. In the case of switching the operation mode of the reflow furnace 17 from the operation mode to the stop mode or in the case of switching the operation mode of the reflow furnace 17 from the stop mode to the operation mode, the "energy-saving mode" may be replaced with the "stop mode" as appropriate. The user inputs the scheduled production start time in the IPC 101 (S101). The scheduled production start time is a time at which the reflow furnace 17 will be in a production start enabled state. The user inputs the start of the energy-saving mode to the IPC 101 (S102). FIG. 5 is a diagram illustrating an example of an operation panel 300 of the IPC 101. The user inputs 16:30 as the scheduled production start time and inputs the start of the energy-saving mode (START) using the operation panel 300 of the IPC 101. The operation panel 300 on the IPC 101 has a display function of receiving an input from a user and displaying various kinds of information. Hereinafter, an example of information display and operation using the operation panel 300 of the IPC 101 will be described, but the present invention is not limited to this example. For example, information may be displayed on a screen of a programmable terminal, and the user may operate the reflow furnace 17 using the programmable terminal. The programmable terminal is connectable to at least one of the PLC 102 and the reflow furnace PLC 103, and the instructions from the programmable terminal are sent to at least one of the PLC 102 and the reflow furnace PLC 103.

The IPC 101 instructs the PLC 102 to switch the reflow furnace 17 to the energy-saving mode (S103). The PLC 102 switches the reflow furnace 17 to the energy-saving mode via the mode output unit 113 and the reflow furnace PLC 103 (S104). Accordingly, the energy-saving mode of the reflow furnace 17 is turned on. The PLC 102 switches the display of the patrol lamp 112 from the operation mode to the standby mode. When the reflow furnace 17 is switched to the stop mode, the PLC 102 switches the display of the patrol lamp 112 from the operation mode to the stop mode.

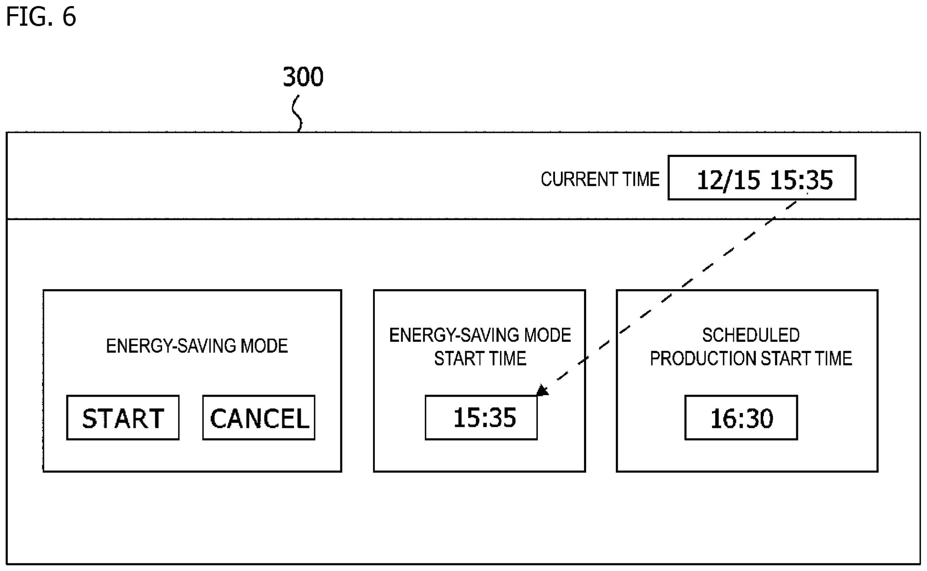

The IPC 101 records the start time of the energy-saving mode in the storage device of the IPC 101 (S105). FIG. 6 is a diagram illustrating an example of the operation panel 300 of the IPC 101. As illustrated in FIG. 6, the current time is recorded as the start time of the energy-saving mode. The IPC 101 calculates a transition time (switching time) (S106).

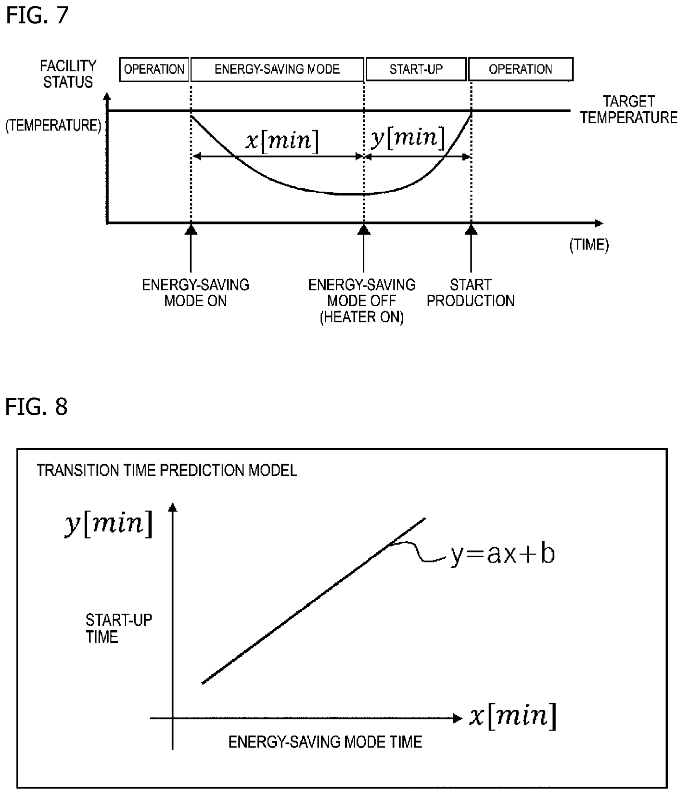

An example of a transition time calculation process will be described with reference to FIGS. 7 to 9. First, an energy-saving mode time (x) and a start-up time (y) will be described. FIG. 7 is an explanatory diagram of the energy-saving mode time (x) and the start-up time (y). The horizontal axis of FIG. 7 represents time (min), and the vertical axis of FIG. 7 represents the temperature of the heater 37. The energy-saving mode time (x) is an elapsed time from the time when the energy-saving mode of the reflow furnace 17 is turned on to the time when the energy-saving mode of the reflow furnace 17 is turned off. In FIG. 7, the time at which the heater 37 is turned on is the time (transition time) at which the energy-saving mode of the reflow furnace 17 is turned off. The start-up time (y) is an elapsed time from the time when the energy-saving mode of the reflow furnace 17 is turned off to the scheduled production start time. When the energy-saving mode of the reflow furnace 17 is turned on, the heater 37 is turned off or the amount of power supplied to the heater 37 is reduced, so that the temperature of the heater 37 is lowered. When the energy-saving mode of the reflow furnace 17 is turned off, the heater 37 is turned on or the amount of power supplied to the heater 37 is increased, and the temperature of the heater 37 rises to the target temperature, so that the reflow furnace 17 enters a state in which the production of workpieces having stable quality can be started (production start enabled state). As illustrated in FIG. 7, the time (transition time) at which the energy-saving mode of the reflow furnace 17 is turned off is determined by the ratio of the energy-saving mode time (x) and the start-up time (y), which are the times before and after the transition time. Therefore, the transition time can be calculated from the relationship between the energy-saving mode time (x) and the start-up time (y).

FIG. 8 is a diagram illustrating a transition time prediction model. The horizontal axis of FIG. 8 represents the energy-saving mode time (x), and the vertical axis of FIG. 8 represents the start-up time (y). The transition time prediction model (linear function model) illustrated in FIG. 8 is a model calculated based on the relationship between the energy-saving mode time (x) and the start-up time (y).

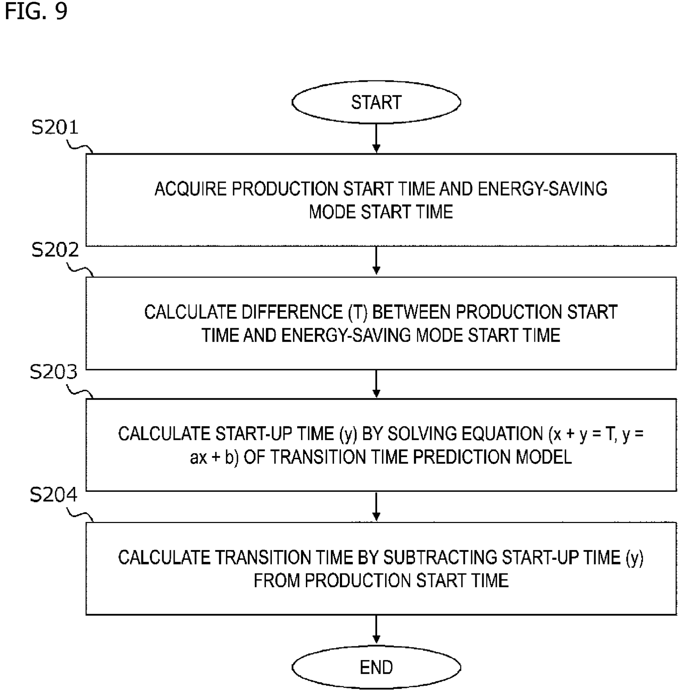

FIG. 9 is a diagram illustrating an example of a flow of calculation processing of transition time. The IPC 101 acquires the scheduled production start time and the start time of the energy-saving mode (S201). The IPC 101 calculates a difference (T) between the scheduled production start time and the start time of the energy-saving mode (S202). The IPC 101 calculates the start-up time (y) using the transition time prediction model illustrated in FIG. 9. That is, the IPC 101 calculates the start-up time (y) by solving the equation (x + y = T, y = ax + b) of the transition time prediction model (S203). The IPC 101 calculates the transition time by subtracting the start-up time (y) from the scheduled production start time (S204). The values of a and b in the equation of the transition time prediction model may be obtained from data accumulated in advance (time data of a plurality of patterns from the start of the energy-saving mode to the actual transition) or may be calculated from data of a plurality of times.

The IPC 101 displays the calculated transition time (S107). The IPC 101 sends the transition time data to the PLC 102 (S108). The PLC 102 monitors the transition time by the timer and waits until the current time reaches the transition time (S109). When the current time reaches the transition time, the PLC 102 switches the reflow furnace 17 from the standby mode to the operation mode via the mode output unit 113 and the reflow furnace PLC 103 (S110). Accordingly, the energy-saving mode of the reflow furnace 17 is turned off. In the switching from the stop mode to the operation mode, when the current time reaches the transition time, the PLC 102 switches the reflow furnace 17 from the stop mode to the operation mode via the mode output unit 113 and the reflow furnace PLC 103. Although not illustrated in FIGS. 5 and 6, the current time may be recorded as the end time of the energy-saving mode. When the reflow furnace 17 enters the operation mode, the supply of power to the heater 37 is started to turn on the heater 37 or increase the amount of power supplied to the heater 37, the opening degrees of the duct 32A and the duct 32B become 100%, and the supply of power to the fans 33A and 33B is started to drive the fans 33A and 33B or increase the amounts of driving of the fans 33A and 33B. The amounts of driving of the fans 33A and 33B may be increased by increasing the rotation speeds of the fans 33A and 33B. The amounts of driving of the fans 33A and 33B may be increased by switching the fans 33A and 33B from intermittent driving to continuous driving.

The PLC 102 may acquire the time (production enabled time) when the reflow furnace 17 enters the production enabled state, via the reflow furnace PLC 103. The PLC 102 sends the production enabled time data to the IPC 101. The IPC 101 calculates the transition time period based on the transition time and the production enabled time. The transition time period is the time (production enabled time - transition time) required from the time when the operation mode of the reflow furnace 17 is switched from the standby mode or the stop mode to the operation mode to the time when the reflow furnace 17 enters the production enabled state. Although not illustrated in FIGS. 5 and 6, the production start enabled time may be recorded as the actual production start time (facility start-up completion trigger).

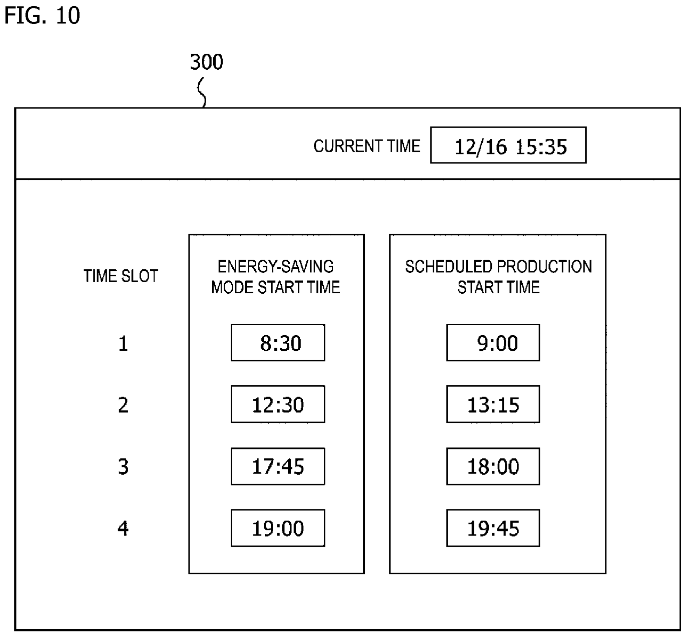

Referring to FIG. 4, the reflow furnace 17 is switched to the energy-saving mode by a mode (input mode) in which the user inputs the scheduled production start time in the IPC 101. The switching of the reflow furnace 17 to the energy-saving mode may be executed by a schedule mode instead of the input mode. FIG. 10 is a diagram illustrating an example of the operation panel 300 of the IPC 101 in a case where the reflow furnace 17 is switched to the energy-saving mode by the schedule mode. The IPC 101 determines the scheduled production start time based on production plan information acquired from an MES (Manufacturing Execution System), and displays the scheduled production start time on the operation panel 300. In addition, the start time of the energy-saving mode is displayed on the operation panel 300 illustrated in FIG. 10. Further, the end time of the energy-saving mode and the actual production start time may be displayed on the operation panel 300.

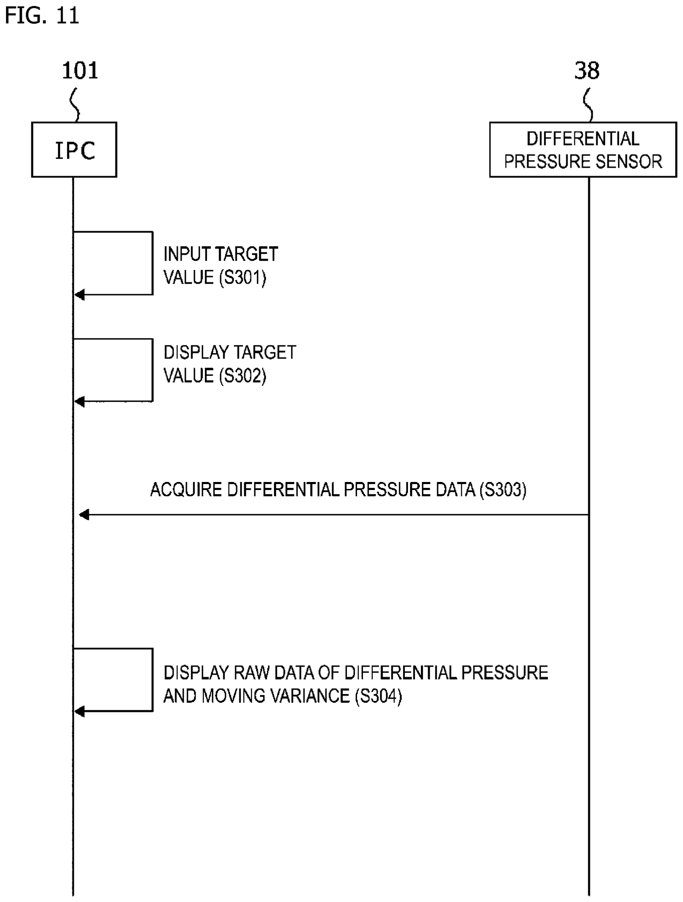

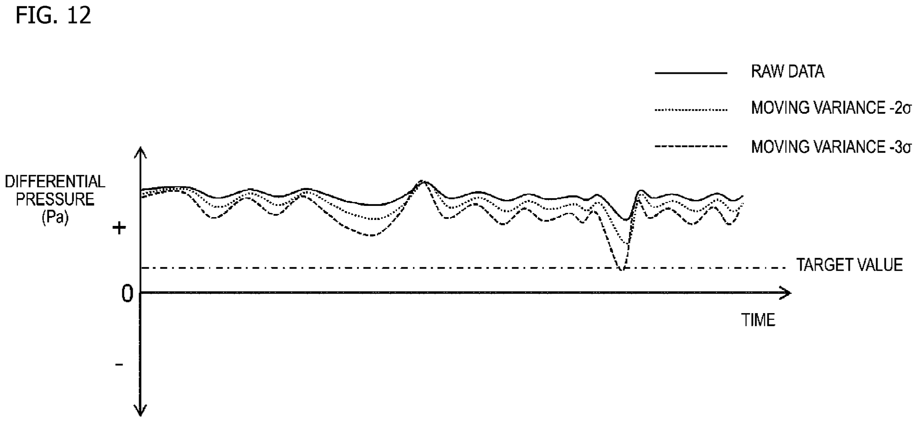

Damper control will be described with reference to FIGS. 11 to 13. FIG. 11 is a diagram illustrating an example of a flow of displaying the differential pressure (P1 - P2) between the pressure P1 in the manufacturing chamber 1 and the pressure P2 in the duct 32 A on the display device of the IPC 101. The IPC 101 receives an input of a target value of the differential pressure (P1 - P2) (S301). For example, the user may input the target value of the differential pressure (P1 - P2) using the user interface of the IPC 101. The IPC 101 displays the target value of the differential pressure (P1 - P2) on the display device (S302). The IPC 101 acquires differential pressure data from the differential pressure sensor 38 (S303). The IPC 101 displays raw data of the differential pressure (P1 - P2) and moving variances -2σ and -3σ of the differential pressure (P1 - P2) at a set interval (Tmin) on the display device (S304). FIG. 12 is a diagram illustrating a display example of the target value, the raw data, and the moving variances -2σ and -3σ of the differential pressure (P1 - P2).

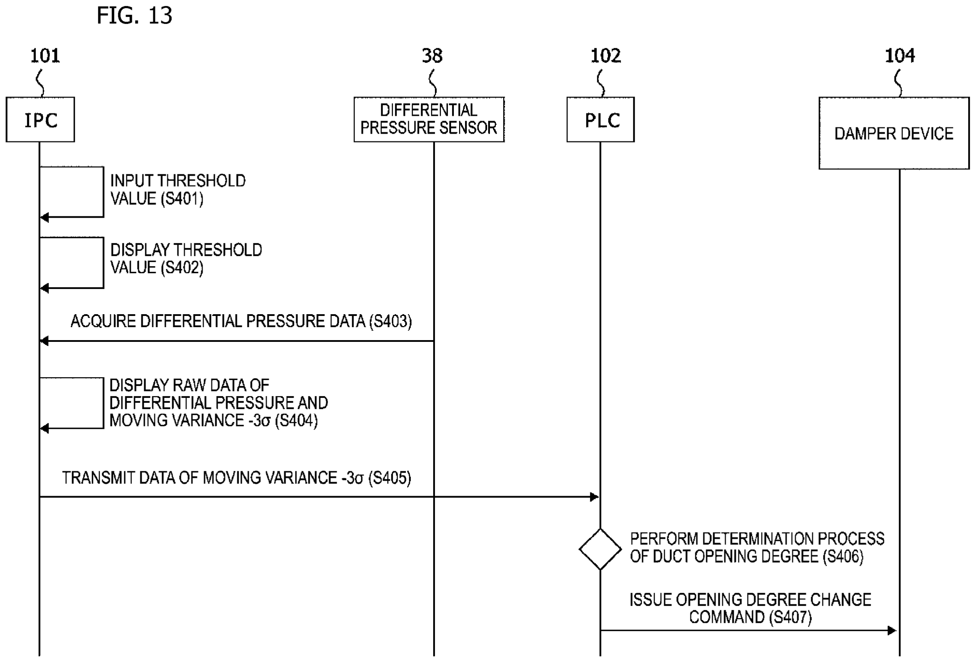

FIG. 13 is a diagram illustrating an example of a flow of damper control. The damper control may be performed constantly or intermittently. The damper control may be performed when the operation mode of the reflow furnace 17 is the operation mode, the standby mode, or the stop mode. The damper control may be performed when the operation mode of the reflow furnace 17 is the operation mode (during the operation mode), and the damper control may be stopped when the operation mode of the reflow furnace 17 is the standby mode or the stop mode. The damper control may be performed when the operation mode of the reflow furnace 17 is the standby mode (during the standby mode), and the damper control may be stopped when the operation mode of the reflow furnace 17 is the operation mode or the stop mode. The damper control may be performed when the operation mode of the reflow furnace 17 is the stop mode (during the stop mode), and the damper control may be stopped when the operation mode of the reflow furnace 17 is the operation mode or the standby mode. The IPC 101 acquires a threshold value by receiving an input of the threshold value of the differential pressure (P1 - P2) (S401). For example, the user may input the threshold value of the differential pressure (P1 - P2) using the user interface of the IPC 101. The IPC 101 may acquire a plurality of threshold values by receiving an input of the plurality of threshold values. In addition, the IPC 101 may determine the threshold value of the differential pressure (P1 - P2) by experiment or simulation. The IPC 101 displays the threshold value of the differential pressure (P1 - P2) on the display device (S402).

The IPC 101 acquires differential pressure data from the differential pressure sensor 38 (S403). The IPC 101 displays the raw data of the differential pressure (P1 - P2) and the moving variance -3σ of the differential pressure (P1 - P2) at the set interval (Tmin) on the display device (S404). In accordance with the user's selection, the IPC 101 may display the raw data of the differential pressure (P1 - P2) and the moving variance -2σ of the differential pressure (P1 - P2) data at the set interval (Tmin) on the display device. The IPC 101 transmits the data of the moving variance -3σ to the PLC 102 (S405). In accordance with the user's selection, the IPC 101 may send the data of the moving variance -2σ or the raw data of the differential pressure (P1 - P2) to the PLC 102.

The PLC 102 performs a determination process of a duct opening degree based on the data of the moving variance -3σ (S406). The PLC 102 may perform the determination process of the duct opening degree based on the raw data of the moving variance -3σ or the raw data of the differential pressure (P1 - P2). The PLC 102 issues an opening degree change command to the damper device 104 based on the result of the determination process of the duct opening degree (S407). The damper device 104 includes damper motors 36A and 36B. The damper motor 36A controls the degree of opening/closing of the opening/closing plate 34A and controls the opening degree of the duct 32A based on the opening degree change command from the PLC 102. The damper motor 36B controls the degree of opening/closing of the opening/closing plate 34B and controls the opening degree of the duct 32B based on the opening degree change command from the PLC 102.

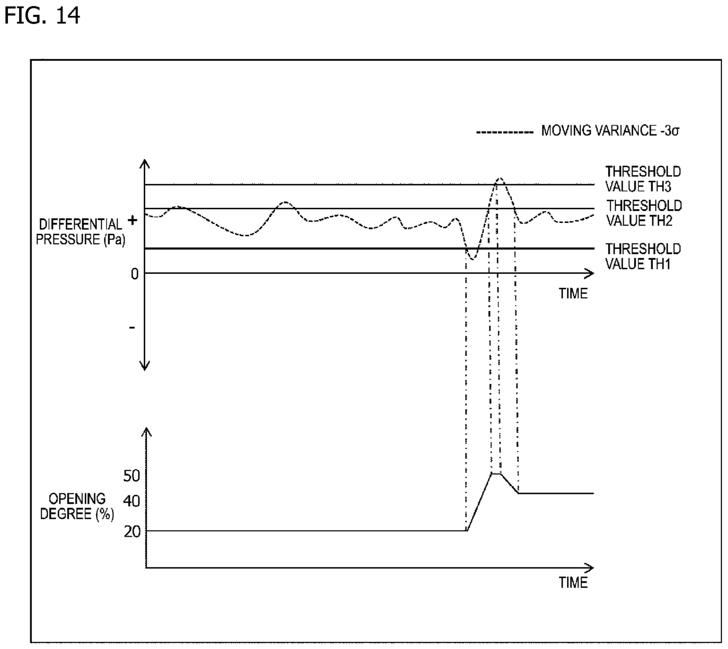

The determination process of the duct opening degree and the control process of the duct opening degree will be described with reference to FIG. 14. FIG. 14 is an explanatory diagram of the determination process of the duct opening degree and the control process of the duct opening degree. FIG. 14 illustrates a process of controlling the opening degree of the duct 32A by controlling the degree of opening/closing of the opening/closing plate 34A based on the moving variance -3σ of the differential pressure (P1 - P2) at the set interval (Tmin). In the example illustrated in FIG. 14, threshold values TH1, TH2, and TH3 are set. If the differential pressure (P1 - P2) becomes equal to or less than the threshold value TH1, the opening degree of the duct 32A is gradually increased. The opening degree (50%) of the duct 32A at the time when the differential pressure (P1 - P2) exceeds the threshold value TH2 is maintained. If the differential pressure (P1 - P2) exceeds the threshold value TH3, the opening degree of the duct 32A is gradually decreased. The opening degree (40%) of the duct 32A at the time when the differential pressure (P1 - P2) becomes equal to or less than the threshold value TH2 is maintained. In this manner, controlling the opening degree of the duct 32A based on the change in the differential pressure (P1 - P2) makes it possible to maintain the differential pressure (P1 - P2) within a certain range, thereby to maintain the inside of the duct 32A under a negative pressure. The control of the opening degree of the duct 32A and the control of the degree of opening/closing of the opening/closing plate 34A can be applied to the control of the opening degree of the duct 32B and the control of the degree of opening/closing of the opening/closing plate 34B. If the exhaust is performed more than necessary from the ducts 32A and 32B in the operation mode, heat loss may increase. In the operation mode, the amounts of exhaust from the ducts 32A and 32B are suppressed by appropriately controlling the opening degrees of the ducts 32A and 32B to such an extent that the gas and foreign matter in the ducts 32A and 32B do not flow back into the manufacturing chamber 1. This enhances the heat retention effect in the reflow furnace 17 while reducing the heat loss, thereby minimizing the energy loss. In the standby mode and the stop mode, the insides of the ducts 32A and 32B are maintained under a negative pressure, so that the gas and foreign matter in the ducts 32A and 32B are suppressed from flowing back into the manufacturing chamber 1.

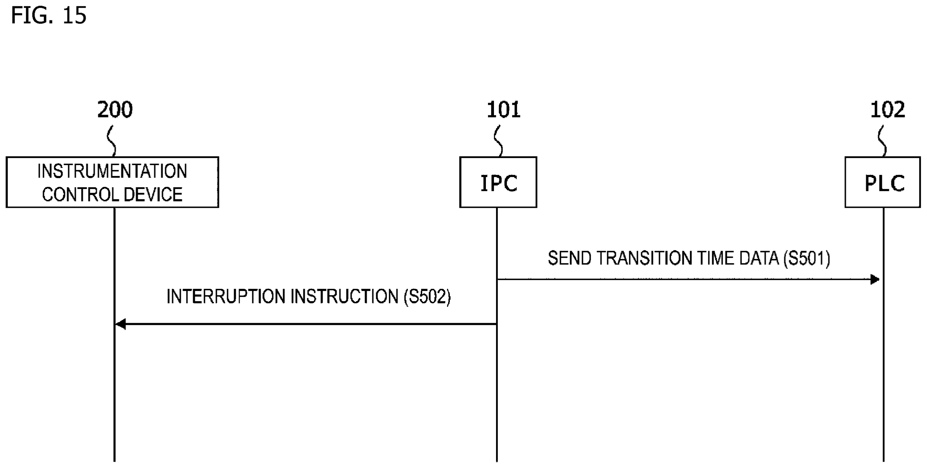

FIG. 15 is a diagram illustrating an example of an instruction flow from the IPC 101 to the instrumentation control device 200. The IPC 101 sends the transition time data to the PLC 102 (S501). After sending the transition time data to the PLC 102, the IPC 101 sends an interrupt instruction to the instrumentation control device 200 (S502). The interrupt instruction is an instruction for increasing the amount of air supply into the manufacturing chamber 1, and includes instructions related to the timing of increasing the amount of air supply into the manufacturing chamber 1 (increase start time), the increase rate (%), and the increase holding time. Before the operation mode of the reflow furnace 17 is switched from the standby mode or the stop mode to the operation mode, the IPC 101 sends the interrupt instruction to the instrumentation control device 200.

The instrumentation control device 200 determines the increase amount of air supply into the manufacturing chamber 1 based on the increase ratio (%) of the amount of air supply into the manufacturing chamber 1. When the current time reaches the increase start time, the instrumentation control device 200 controls the air conditioning facility 2, and the air conditioning facility 2 increases the amount of air supply into the manufacturing chamber 1. The instrumentation control device 200 controls the air conditioning facility 2 such that the state in which the amount of air supply into the manufacturing chamber 1 is increased is maintained until after a lapse of the increase holding time of the amount of air supply into the manufacturing chamber 1. When the operation mode of the reflow furnace 17 is switched from the standby mode to the operation mode, the supply of power to the fans 33A and 33B is started to drive the fans 33A and 33B, and the gas in the interior of the hollow part of the reflow furnace 17 is emitted out of the manufacturing chamber 1. Alternatively, when the operation mode of the reflow furnace 17 is switched from the standby mode to the operation mode, the amounts of driving the fans 33A and 33B increase, and the amount of emission of the gas from the interior of the hollow part of the reflow furnace 17 increases. Therefore, the amount of air supply from the inside of the manufacturing chamber 1 in a case where the operation mode of the reflow furnace 17 is the operation mode increases as compared with a case where the operation mode of the reflow furnace 17 is the standby mode. In the present embodiment, before the operation mode of the reflow furnace 17 is switched from the standby mode to the operation mode, that is, before the reflow furnace 17 transitions from the second state to the first state, the instrumentation control device 200 that controls the air conditioning facility 2 is instructed to increase the amount of air supply into the manufacturing chamber 1, so that the inside of the manufacturing chamber 1 can be maintained under a positive pressure even if the amount of air supply from the inside of the manufacturing chamber 1 increases.

When the operation mode of the reflow furnace 17 is switched from the stop mode to the operation mode, the supply of power to the fans 33A and 33B is started to drive the fans 33A and 33B, and the gas in the interior of the hollow part of the reflow furnace 17 is emitted out of the manufacturing chamber 1. Therefore, the amount of air supply from the inside of the manufacturing chamber 1 in a case where the operation mode of the reflow furnace 17 is the operation mode increases as compared with a case where the operation mode of the reflow furnace 17 is the stop mode. In the present embodiment, before the operation mode of the reflow furnace 17 is switched from the stop mode to the operation mode, that is, before the reflow furnace 17 transitions from the second state to the first state, the instrumentation control device 200 that controls the air conditioning facility 2 is instructed to increase the amount of air supply into the manufacturing chamber 1, so that the inside of the manufacturing chamber 1 can be maintained under a positive pressure even if the amount of air supply from the inside of the manufacturing chamber 1 increases.

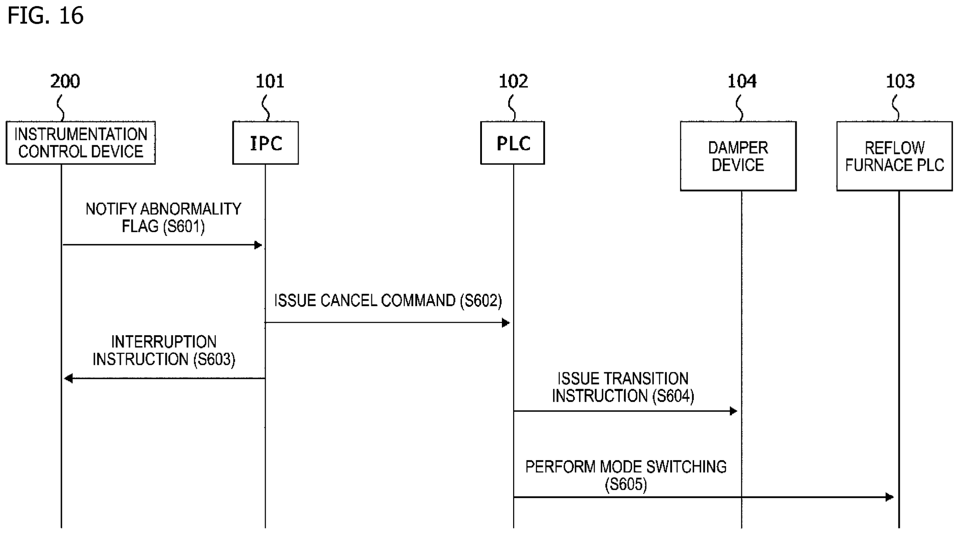

FIG. 16 is a diagram illustrating an example of a control flow in a case where an abnormality occurs in the standby mode or the stop mode. Control in a case where an abnormality occurs in the standby mode will be described. In the control in a case where an abnormality occurs in the stop mode, the "energy-saving mode" and the "standby mode" may be replaced with the "stop mode" as appropriate. The instrumentation control device 200 notifies the IPC 101 of an abnormality flag (S601). The IPC 101 sends a cancel command of the energy-saving mode to the PLC 102 (S602). When receiving a cancel input of the energy-saving mode from the user, the IPC 101 sends a cancel command of the energy-saving mode to the PLC 102.

The IPC 101 sends an interrupt instruction to the instrumentation control device 200 (S603). The interrupt instruction is an instruction for increasing the amount of air supply into the manufacturing chamber 1, and includes instructions related to the timing of increasing the amount of air supply into the manufacturing chamber 1 (increase start time), the increase rate (%), and the increase holding time. The instrumentation control device 200 determines the increase amount of air supply into the manufacturing chamber 1 based on the increase ratio (%) of the amount of air supply into the manufacturing chamber 1. When the current time reaches the increase start time, the instrumentation control device 200 controls the air conditioning facility 2 to increase the amount of air supply into the manufacturing chamber 1. The instrumentation control device 200 holds the state in which the amount of air supply into the manufacturing chamber 1 is increased until after a lapse of the increase holding time of the amount of air supply into the manufacturing chamber 1.

The PLC 102 sends a transition instruction to the damper device 104 such that the opening degrees of the ducts 32A and 32B become 100% (S604). The damper motor 36A controls the degree of opening/closing of the opening/closing plate 34A such that the opening degree of the duct 32A becomes 100% based on the transition instruction from the PLC 102. The damper motor 36B controls the degree of opening/closing of the opening/closing plate 34B such that the opening degree of the duct 32B becomes 100% based on the instruction from the PLC 102.

The PLC 102 sends a switch instruction of the energy-saving mode of the reflow furnace 17 to the reflow furnace PLC 103 (S605). The reflow furnace PLC 103 switches the operation mode of the reflow furnace 17 from the standby mode to the operation mode. Accordingly, the energy-saving mode of the reflow furnace 17 is turned off. When the operation mode of the reflow furnace 17 is switched from the standby mode to the operation mode, the supply of power to the heater 37 is started to turn on the heater 37 or increase the amount of power supply to the heater 37, and the supply of power to the fans 33A and 33B is started to drive the fans 33A and 33B or increase the amount of driving of the fans 33A and 33B. When the operation mode of the reflow furnace 17 is switched from the stop mode to the operation mode, the supply of power to the heater 37 is started to turn on the heater 37, and the supply of power to the fans 33A and 33B is started to drive the fans 33A and 33B.

In the operation mode, the supply of power to the heater 37 is started to turn on the heater 37 or increase the amount of power supply to the heater 37, and the temperature of the heater 37 is maintained at the target temperature. Accordingly, the temperature in the reflow furnace 17 is maintained in a state where it is possible to start production of workpieces with stable quality. In the operation mode, the supply of power to the fans 33A and 33B is started to drive the fans 33A and 33B, so that the gas generated in the reflow furnace 17 is emitted out of the manufacturing chamber 1 through the ducts 32A and 32B and the air supply ports 3C and 3D provided in the manufacturing chamber 1. Accordingly, the gas generated in the reflow furnace 17 is emitted out of the manufacturing chamber 1 without being released into the manufacturing chamber 1. If the input of the workpiece into the reflow furnace 17 is temporarily stopped, the operation mode of the reflow furnace 17 is switched from the operation mode to the standby mode, the supply of power to the fans 33A and 33B is stopped to stop the driving of the fans 33A and 33B or reduce the amounts of driving of the fans 33A and 33B, and the supply of power to the heater 37 is stopped or the supply amount of power to the heater 37 is reduced. This suppresses energy consumption. If the input of the workpiece into the reflow furnace 17 is stopped for a long time, the operation mode of the reflow furnace 17 is switched from the operation mode to the stop mode, the supply of power to the fans 33A and 33B is stopped to stop the driving of the fans 33A and 33B, and the supply of power to the heater 37 is stopped. This suppresses energy consumption.

To resume production, the operation mode of the reflow furnace 17 is switched from the standby mode to the operation mode, and the supply of power to the fans 33A and 33B is started to resume the driving of the fans 33A and 33B or increase the amounts of driving of the fans 33A and 33B, and the supply of power to the heater 37 is resumed or the supply amount of power to the heater 37 is increased. Alternatively, the operation mode of the reflow furnace 17 is switched from the stop mode to the operation mode, the supply of power to the fans 33A and 33B is started to drive the fans 33A and 33B, and the supply of power to the heater 37 is started. However, even if the operation mode of the reflow furnace 17 is switched from the standby mode or the stop mode to the operation mode, the temperature in the reflow furnace 17 will not immediately reach the target temperature, and a certain amount of time will be required until the temperature in the reflow furnace 17 reaches the target temperature. The time required from when the reflow furnace 17 is switched to the operation mode (transition time T0) to when the temperature in the reflow furnace 17 reaches the target temperature and the reflow furnace 17 enters the production start enabled state (time T1) will be called transition time period RT (= T1 - T0). The transition time period varies depending on the device configuration, the operation condition, the production item (the type of the product), and the like.

In the present embodiment, the IPC 101 measures the actual time required for the reflow furnace 17 to actually enter the production start enabled state from the transition time, and automatically updates (learns) the set value of the transition time period based on the measurement value, thereby optimizing the mode switching timing. Hereinafter, a specific configuration of control by the IPC 101 will be described in detail.

### (Functional Blocks)

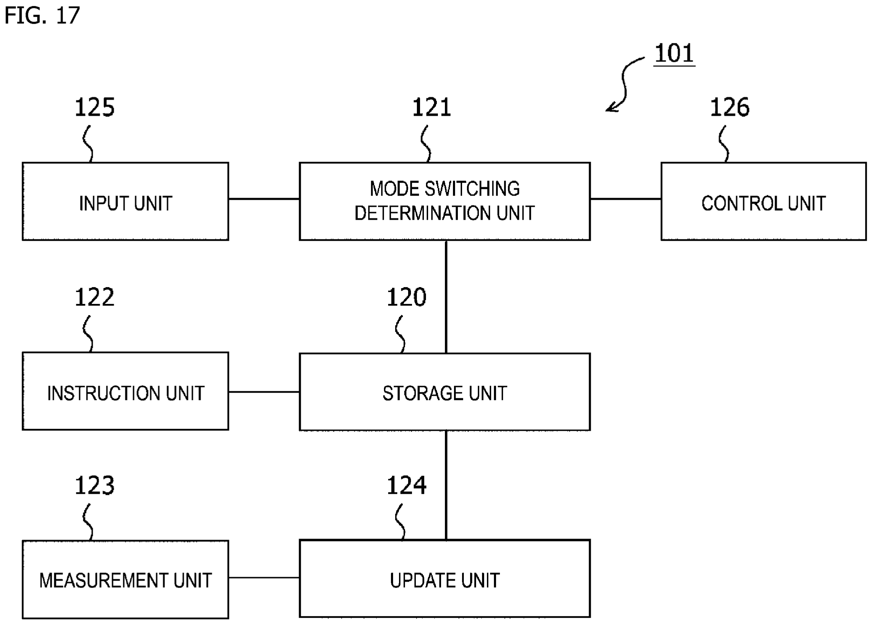

FIG. 17 is a block diagram illustrating a functional configuration of the IPC 101. The functions of the IPC 101 consist of a storage unit 120, a mode switching determination unit 121, an instruction unit 122, a measurement unit 123, an update unit 124, an input unit 125, and a control unit 126. The storage unit 120 is a function of storing a set value, a measurement value, and the like of the transition time period, and is implemented by using a storage device such as a memory or a storage. The mode switching determination unit 121 has a function of determining switching of the operation mode (operation mode/standby mode/stop mode) of the reflow furnace 17. The instruction unit 122 is a function of giving an instruction (interrupt instruction) to increase the amount of air supply into the manufacturing chamber 1 with respect to the air conditioning facility 2 via the instrumentation control device 200.

The measurement unit 123 is a function of measuring, by a timer, a time (second transition time period) actually required for the reflow furnace 17 to enter the production start enabled state after the operation mode of the reflow furnace 17 is switched from the standby mode or the stop mode to the operation mode. The update unit 124 is a function of updating the set value of the transition time period stored in the storage unit 120 based on the measurement value of the second transition time period measured by the measurement unit 123. The input unit 125 is a function of receiving an input of information and data from the user. The control unit 126 is a function of controlling the opening degrees of the ducts 32A and 32B based on the differential pressure between the pressure P1 in the manufacturing chamber 1 and the pressure P2 in the duct 32A when the reflow furnace 17 is in the standby mode or the stop mode. The control unit 126 also functions as an arithmetic unit (calculation unit) that performs various arithmetic operations and calculations.

The various functions illustrated in FIG. 17 are implemented by a computer such as a CPU in the IPC 101 executing a program stored in a storage device in the IPC 101. Not all the functions of the IPC 101 illustrated in FIG. 17 are essential, and functions of the IPC 101 may be added or deleted as appropriate. For example, all or some of the functions of the IPC 101 illustrated in FIG. 17 may be configured by a circuit such as an application-specific integrated circuit (ASIC) or a field programmable gate array (FPGA), or all or some of the functions of the IPC 101 may be executed by a cloud server or another device.

Next, operations of the various functions illustrated in FIG. 17 will be described. The instruction unit 122 or the control unit 126 calculates a set value of the transition time period expected to be required for the reflow furnace 17 to enter the production start enabled state from the state (second state) in which the reflow furnace 17 is in the standby mode or the stop mode. For example, the instruction unit 122 or the control unit 126 may calculate the start-up time (y) using the transition time prediction model illustrated in FIG. 17 based on the scheduled production start time and the start time of the energy-saving mode, and may calculate the start-up time (y) as the set value of the transition time period. The storage unit 120 stores the set value of the transition time period calculated by the instruction unit 122 or the control unit 126.

When the operation mode of the reflow furnace 17 is the operation mode, if a command to switch to the standby mode or the stop mode is issued, the mode switching determination unit 121 determines to switch the operation mode of the reflow furnace 17 to the standby mode or the stop mode. The command to switch to the standby mode or the stop mode is issued when the IPC 101 receives an input from the user. In addition, the command to switch to the standby mode or the stop mode may be issued based on schedule information in which a predetermined time (a break start time, a shift change time, or the like) is set.

The instruction unit 122 instructs the air conditioning facility 2 to increase the amount of air supply into the manufacturing chamber 1 (interrupt instruction) via the instrumentation control device 200 before the operation mode of the reflow furnace 17 is switched from the standby mode or the stop mode to the operation mode, that is, before the reflow furnace 17 transitions from the second state to the first state. The interrupt instruction includes instructions related to the timing of increasing the amount of air supply into the manufacturing chamber 1 (increase start time), the increase rate (%), and the increase holding time.

The instruction unit 122 determines a switching time (transition time) at which the operation mode of the reflow furnace 17 is switched from the standby mode or the stop mode to the operation mode, based on the time (scheduled production start time) at which the reflow furnace 17 is scheduled to enter the production start enabled state and the set value of the transition time period stored in the storage unit 120. For example, the instruction unit 122 determines a value obtained by subtracting the set value of the transition time period from the scheduled production start time as the switching time (transition time). When the current time reaches the switching time (transition time), the operation mode of the reflow furnace 17 is switched from the standby mode or the stop mode to the operation mode, and the amount of air supply from the inside of the manufacturing chamber 1 increases. Therefore, the instruction unit 122 determines the timing of increasing the amount of air supply into the manufacturing chamber 1 based on the switching time (transition time).

The measurement unit 123 measures one or more times, the time (second transition time period) actually required for the reflow furnace 17 to enter the production start enabled state after the operation mode of the reflow furnace 17 is switched from the standby mode or the stop mode to the operation mode. The measurement unit 123 may store the measurement value(s) of the second transition time period measured one or more times in the storage unit 120. The update unit 124 updates the set value of the transition time period stored in the storage unit 120 based on the measurement value(s) of the second transition time period measured one or more times. Since the set value of the transition time period can be updated (learned) using the measurement value(s) of the second transition time period measured one or more times, the set value of the transition time period can be automatically optimized during operation of the reflow furnace 17. Although the transition time period may vary even in the same production facility due to differences in operation conditions or installation environment, aging deterioration, and the like, it is possible to automatically set a proper transition time period by updating the set value as appropriate based on the measurement value as in the present embodiment.

The storage unit 120 may store each type of product produced by the reflow furnace 17 and the set value of the transition time period for each type of product in association with each other. The measurement unit 123 measures the second transition time period for each type of product one or more times. The update unit 124 updates the set value of the transition time period for each type of product stored in the storage unit 120, based on the measurement value(s) of the second transition time period for each type of product measured one or more times. Since the set value of the transition time period for each type of product can be updated (learned) using the measurement value(s) of the second transition time period measured one or more times for each type of product, the set value of the transition time period for each type of product can be automatically optimized during operation of the reflow furnace 17. If the type of the product changes, the transition time period may vary. However, an appropriate transition time period can be automatically set by updating the set value as appropriate based on the value(s) measured for each type of the product.

The storage unit 120 may store the operation parameters related to the operation of the reflow furnace 17 and the set value of the transition time period for each operation parameter in association with each other. The operation parameters include at least one of the type of the product produced by the reflow furnace 17, the type of material of the product produced by the reflow furnace 17, the type of the method used in the reflow furnace 17, the worker information of the worker who is engaged in the reflow furnace 17 in the operation mode, the facility information of the reflow furnace 17, and the external environment information around the reflow furnace 17. The external environment information around the reflow furnace 17 includes temperature information, humidity information, and the like of the surroundings of the reflow furnace 17. The measurement unit 123 measures the second transition time period for each operation parameter one or more times. The update unit 124 updates the set value of the transition time period for each operation parameter stored in the storage unit 120, based on the measurement value of the second transition time period for each operation parameter measured one or more times. Since the set value of the transition time period for each operation parameter can be updated (learned) using the measurement value of the second transition time period for each operation parameter measured one or more times, the set value of the transition time period for each operation parameter can be automatically optimized under operation of the reflow furnace 17. The user may input the operation parameters to the IPC 101, or the IPC 101 may acquire the operation parameters from various sensors. The present invention is not limited to these methods, and the IPC 101 may acquire the operation parameters by other methods.

Although a control example has been described in which the PLC 102 controls the opening degrees of the ducts 32A and 32B based on the differential pressure between the pressure in the manufacturing chamber 1 and the pressure in the duct 32A, the present invention is not limited to this control example. The control unit 126 may control the opening degrees of the ducts 32A and 32B based on the differential pressure between the pressure in the manufacturing chamber 1 and the pressure in the duct 32A. The control unit 126 may control the opening degrees of the ducts 32A and 32B based on the differential pressure between the pressure in the manufacturing chamber 1 and the pressure in the duct 32B. The control unit 126 is an example of a duct control unit.

Although an example has been described above in which the IPC 101, the PLC 102, and the reflow furnace PLC 103 operate in cooperation with each other to provide the functions of the control device 100, the present embodiment is not limited to this example. Two of the IPC 101, the PLC 102, and the reflow furnace PLC 103 may operate in cooperation with each other to provide the functions of the control device 100. Alternatively, one of the IPC 101, the PLC 102, and the reflow furnace PLC 103 may operate to provide the functions of the control device 100. In addition, at least one of the functions of the IPC 101 may be provided by the PLC 102 and the reflow furnace PLC 103. At least one of the functions of the PLC 102 may be provided by the IPC 101 and the reflow furnace PLC 103. At least one of the functions of the reflow furnace PLC 103 may be provided by the IPC 101 and the PLC 102.

### <Others>

The above-described embodiments and variations are merely illustrative configuration examples of the present invention. The present invention is not limited to the specific aspects described above, and various modifications are possible within the scope of the technical idea of the present invention.

Each process described above may be regarded as a method executed by a computer. Further, a program for causing a computer to execute each process described above may be provided to the computer via a network or from a computer-readable recording medium or the like that holds data in a non-transitory manner.

### <Supplementary Note 1>

A control device (100) for at least one production facility having a first mode of maintaining a first state in which an interior of a hollow part of the production facility is heated and gas in the interior of the hollow part is emitted out of a manufacturing chamber (1) and a second mode of maintaining a second state in which energy consumption is lower than in the first state, the control device (100) including an instruction unit (122) that issues an instruction for increasing an amount of air supply into the manufacturing chamber (1) to an air conditioning control unit (200) that controls an air conditioning facility (2) that maintains a positive pressure in the manufacturing chamber (1) in which the production facility is arranged before the production facility transitions from the second state to the first state.

### <Supplementary Note 2>

The control device (100) according to Supplementary Note 1, wherein the instruction for increasing the amount of air supply into the manufacturing chamber (1) includes an instruction related to a timing of increasing the amount of air supply into the manufacturing chamber (1), an increase rate, and an increase holding time.

### <Supplementary Note 3>

The control device (100) according to Supplementary Note 2, further including a storage unit (120) that stores a set value of a transition time period expected to be required for the production facility to enter a production start enabled state from the second state, wherein
the instruction unit (122) determines a switching time at which switching from the second mode to the first mode is performed, based on a time at which the production facility (17) enters the production start enabled state and the set value of the transition time period stored in the storage unit (120), and determines the timing of increasing the amount of air supply into the manufacturing chamber (1), based on the switching time.

### <Supplementary Note 4>

The control device (100) according to Supplementary Note 3, further including: a measurement unit (123) that measures a second transition time period actually required until the production facility enters the production start enabled state after switching from the second mode to the first mode one or more times; and
an update unit (124) that updates the set value of the transition time period stored in the storage unit (120) based on a measurement value of the second transition time period measured one or more times by the measurement unit

(123).

### <Supplementary Note 5>

The control device (100) according to Supplementary Note 4, wherein
the storage unit (120) stores operation parameters related to an operation of the production facility and the set value of the transition time period for each of the operation parameters in association with each other,
the measurement unit (123) measures the second transition time period for each of the operation parameters one or more times, and
the update unit (124) updates the set value of the transition time period for each of the operation parameters stored in the storage unit (120), based on the measurement value of the second transition time period for each of the operation parameters measured by the measurement unit (123) one or more times.

### <Supplementary Note 6>

The control device according to Supplementary Note 5, wherein the operation parameters include at least one of a type of a product produced by the production facility, worker information of a worker who is engaged in the production facility in the first mode, facility information of the production facility, external environment information of surroundings of the production facility, a type of a material of the product, and a type of a method used in the production facility.

### <Supplementary Note 7>

The control device (100) according to any one of Supplementary Notes 1 to 6, wherein
the production facility is a reflow furnace (17) that heats solder paste on a substrate,
the first mode is an operation mode in which power is supplied to a heater (37) in the reflow furnace (17) to heat an inside of the reflow furnace (17) and power is supplied to a fan (33A, 33B) in the reflow furnace (17) to emit gas in the reflow furnace (17) out of the manufacturing chamber (1), and
the second mode is a standby mode of being on standby in the second state while supply of power to the heater (37) is stopped or an amount of power supply to the heater (37) is reduced, and the supply of power to the fan (33A, 33B) is stopped or an amount of driving of the fan is reduced.

### <Supplementary Note 8>

The control device (100) according to any one of Supplementary Notes 1 to 6, wherein
the production facility is a reflow furnace (17) that heats solder paste on a substrate,
the first mode is an operation mode in which power is supplied to a heater (37) in the reflow furnace (17) to heat an inside of the reflow furnace (17) and power is supplied to a fan (33A, 33B) in the reflow furnace (17) to emit gas in the reflow furnace (17) out of the manufacturing chamber (1), and
the second mode is a stop mode in which the supply of power to the heater (37) and the fan (33A, 33B) is stopped to stop operation.

### <Supplementary Note 9>

The control device (100) according to any one of Supplementary Notes 1 to 8, wherein
the production facility has a duct for emitting the gas out of the manufacturing chamber (1), and
the production facility includes a duct control unit that controls an opening degree of the duct based on a differential pressure between a pressure in the manufacturing chamber (1) and a pressure in the duct.

### <Supplementary Note 10>

A control method for at least one production facility (17) having a first mode of maintaining a first state in which an interior of a hollow part of the production facility is heated and gas in the interior of the hollow part is emitted out of a manufacturing chamber (1) and a second mode of maintaining a second state in which energy consumption is lower than in the first state, the control method including
issuing an instruction for increasing an amount of air supply into the manufacturing chamber (1) to an air conditioning control unit (200) that controls an air conditioning facility (2) that maintains a positive pressure in the manufacturing chamber (1) in which the production facility (17) is arranged before the production facility (17) transitions from the second state to the first state.

### <Supplementary Note 11>

A control program for causing a control device for at least one production facility (17) having a first mode of maintaining a first state in which an interior of a hollow part of the production facility is heated and gas in the interior of the hollow part is emitted out of a manufacturing chamber (1) and a second mode of maintaining a second state in which energy consumption is lower than in the first state, to execute:
issuing an instruction for increasing an amount of air supply into the manufacturing chamber (1) to an air conditioning control unit (200) that controls an air conditioning facility (2) that maintains a positive pressure in the manufacturing chamber (1) in which the production facility (17) is arranged before the production facility (17) transitions from the second state to the first state.

### REFERENCE SIGNS

1: Manufacturing chamber
2: Air conditioning facility
17: Reflow furnace
21, 24, 35A, 35B: Inverter
22, 25: Air supply fan
23, 26: Air supply device
27, 38: Differential pressure sensor
32A, 32B: Duct
33A, 33B: Fan
34A, 34B: Opening/closing plate
36A, 36B: Damper motor
37: Heater
100: Control device
101: IPC
102: PLC
103: Reflow furnace PLC
200: Instrumentation control device

## Claims

1. A control device for at least one production facility having a first mode of maintaining a first state in which a hollow part of the production facility is heated and gas in an interior of the hollow part is emitted out of a manufacturing chamber and a second mode of maintaining a second state in which energy consumption is lower than in the first state, the control device comprising:
an instruction unit that issues an instruction for increasing an amount of air supply into the manufacturing chamber to an air conditioning control unit that controls an air conditioning facility that maintains a positive pressure in the manufacturing chamber in which the production facility is arranged before the production facility transitions from the second state to the first state.

2. The control device according to claim 1, wherein the instruction for increasing the amount of air supply into the manufacturing chamber includes an instruction related to a timing of increasing the amount of air supply into the manufacturing chamber, an increase rate, and an increase holding time.

3. The control device according to claim 2, further comprising a storage unit that stores a set value of a transition time period expected to be required for the production facility to enter a production start enabled state from the second state, wherein
the instruction unit determines a switching time at which switching from the second mode to the first mode is performed based on a time at which the production facility enters the production start enabled state and the set value of the transition time period stored in the storage unit, and determines the timing of increasing the amount of air supply into the manufacturing chamber based on the switching time.

4. The control device according to claim 3, further comprising:
a measurement unit that measures a second transition time period actually required until the production facility enters the production start enabled state after switching from the second mode to the first mode one or more times; and
an update unit that updates the set value of the transition time period stored in the storage unit based on a measurement value of the second transition time period measured one or more times by the measurement unit.

5. The control device according to claim 4, wherein
the storage unit stores operation parameters related to an operation of the production facility and the set value of the transition time period for each of the operation parameters in association with each other,
the measurement unit measures the second transition time period for each of the operation parameters one or more times, and
the update unit updates the set value of the transition time period for each of the operation parameters stored in the storage unit, based on the measurement value of the second transition time period for each of the operation parameters measured by the measurement unit one or more times.

6. The control device according to claim 5, wherein the operation parameters include at least one of a type of a product produced by the production facility, worker information of a worker who is engaged in the production facility in the first mode, facility information of the production facility, external environment information of surroundings of the production facility, a type of a material of the product, and a type of a method used in the production facility.

7. The control device according to claim 1, wherein
the production facility is a reflow furnace that heats solder paste on a substrate,
the first mode is an operation mode in which power is supplied to a heater in the reflow furnace to heat an inside of the reflow furnace and power is supplied to a fan in the reflow furnace to emit gas in the reflow furnace out of the manufacturing chamber, and
the second mode is a standby mode of being on standby in the second state while supply of power to the heater is stopped or an amount of power supply to the heater is reduced, and the supply of power to the fan is stopped or an amount of driving of the fan is reduced.

8. The control device according to claim 1, wherein
the production facility is a reflow furnace that heats solder paste on a substrate,
the first mode is an operation mode in which power is supplied to a heater in the reflow furnace to heat an inside of the reflow furnace and power is supplied to a fan in the reflow furnace to emit gas in the reflow furnace out of the manufacturing chamber, and
the second mode is a stop mode in which the supply of power to the heater and the fan is stopped to stop operation.

9. The control device according to any one of claims 1 to 8,
wherein
the production facility has a duct for emitting the gas out of the manufacturing chamber, and
the production facility includes a duct control unit that controls an opening degree of the duct based on a differential pressure between a pressure in the manufacturing chamber and a pressure in the duct.

10. A control method for at least one production facility having a first mode of maintaining a first state in which a hollow part of the production facility is heated and gas in an interior of the hollow part is emitted out of a manufacturing chamber and a second mode of maintaining a second state in which energy consumption is lower than in the first state, the control method comprising:
issuing an instruction for increasing an amount of air supply into the manufacturing chamber to an air conditioning control unit that controls an air conditioning facility that maintains a positive pressure in the manufacturing chamber in which the production facility is arranged before the production facility transitions from the second state to the first state.

11. A control program for causing a control device for at least one production facility having a first mode of maintaining a first state in which an interior of a hollow part of the production facility is heated and gas in the interior of the hollow part is emitted out of a manufacturing chamber and a second mode of maintaining a second state in which energy consumption is lower than in the first state, to execute:
issuing an instruction for increasing an amount of air supply into the manufacturing chamber to an air conditioning control unit that controls an air conditioning facility that maintains a positive pressure in the manufacturing chamber in which the production facility is arranged before the production facility transitions from the second state to the first state.
